Europäisches Patentamt

European Patent Office

Office européen des brevets

(19)

(11) Publication number: 0 108 251
A2

# (12) EUROPEAN PATENT APPLICATION

(21) Application number: 83109921.3

(22) Date of filing: 04.10.83

(51) Int. Cl.³: H 01 L 23/52
H 01 L 23/28, H 01 L 29/62

(30) Priority: 08.10.82 JP 176129/82

(43) Date of publication of application:
16.05.84 Bulletin 84/20

(84) Designated Contracting States:
DE FR GB NL

(71) Applicant: HITACHI, LTD.
6, Kanda Surugadai 4-chome Chiyoda-ku
Tokyo 100(JP)

(72) Inventor: Kobayashi, Nobuyoshi
2-32-D405, Koyasu-cho
Hachioji-shi Tokyo(JP)

(72) Inventor: Iwata, Seiichi
19-13, Kami-okutomi
Sayama-shi Saitama-ken(JP)

(72) Inventor: Yamamoto, Naoki
1-10-20, Shiba
Kawaguchi-shi Saitama-ken(JP)

(74) Representative: Strehl, Peter et al,
Dipl.-Ing. P. Strehl Dr. U. Schübel-Hopf Dr. R. Schulz
Patentanwälte Widenmayerstrasse 17 Postfach 22 03 45
D-8000 München 22(DE)

(54) A semiconductor device comprising an electrode and/or an interconnection.

(57) A semiconductor device comprising an electrode or interconnection made of an insulator film (2), a tungsten film (3) and a phosphosilicate glass film (4) which are stacked and formed on a semiconductor substrate (1). Canneling attributed to the punch-through of ions during ion implantation and fluctuations in the threshold voltage can be effectively prevented, so that the semiconductor device has stable characteristics.

FIG. Ib

EP 0 108 251 A2

Semiconductor device

## Background of the Invention

### Field of the Invention

The present invention relates to semiconductor devices, and more particularly to a semiconductor device which employs tungsten as the electrically conductive material of electrodes or interconnections.

### Description of the Prior Art

As is well known, Al (aluminum) has heretofore been extensively used as the electrode material of semiconductor devices.     Al, however, has a low melting point and a poor thermal resistance, so that when the source and drain regions of a MOS transistor are formed by ion implantation using the gate electrode of     Al as a mask, the gate of the MOS transistor melts due to annealing of high temperature which follows the ion implantation.

At present, therefore, a method is most often performed in which a gate made of polycrystalline silicon higher in the melting point than     Al is used as a mask for forming source and drain regions by the ion implantation.

According to this method, since the melting point of the polycrystalline silicon is much higher than that of Al, there is no risk of the gate to be melted or deformed even by the annealing step of high temperature, which must be executed after the ion implantation in order to remove distortions caused by the ion implantation, and a good MOS transistor can be formed.

Polycrystalline silicon, however, is lower in the electric conductivity than metals such as the Al. Therefore, as semiconductor devices have come to have enhanced densities of integration and the widths and thicknesses of electrodes and interconnections have become extremely small, the use of polycrystalline silicon as the electrode material has become increasingly difficult.

Accordingly, it has become necessary to use a material which has a high melting point and a high electric conductivity, and there have been proposed semiconductor devices which employ W (tungsten) or Mo (molybdenum) as the electrode material thereof.

In general, an electrode or interconnection made of W or Mo is formed on an insulator film, such as $SiO_2$ film, formed on a semiconductor substrate and has a structure of W (or Mo)/$SiO_2$.

Since, however, W and Mo are much more liable to oxidation as compared with Si (silicon) etc., it is difficult to form a semiconductor device which is provided with electrodes or interconnections of the W/$SiO_2$ structure.

Moreover, when a gate having the $W/SiO_2$ structure is made and is used as a mask for forming a source and a drain by ion implantation, there arises a phenomenon called "channeling" wherein some ions pass through the gate to be implanted into the region of the semiconductor substrate between the source and the drain. Therefore, a good MOS transistor cannot be formed.

Besides, in using W or Mo for the electrode or interconnection, there have been a large number of problems including the problem that the characteristics of the interface between the W or Mo film and the $SiO_2$ film are inferior.

It has also been proposed to replace the aforementioned $SiO_2$ film with a PSG (phosphosilicate glass) film as the insulator film which intervenes between the W or Mo film and the semiconductor substrate. However, the problems of the oxidation of W and Mo and the channeling are involved similarly to the case of employing $SiO_2$ and remain unsolved.

Summary of the Invention

An object of the present invention is to solve the problems of the prior arts described above, and to provide a semiconductor device which can effectively prevent oxidation in a process for producing the semiconductor device and which is not prone to cause the channeling phenomenon.

Another object of the present invention is to provide a semiconductor device which includes an electrode employing W as an electrically conductive material and in which fluctuations of the threshold voltage $V_{TH}$ and lowering of the breakdown voltage of an insulator film are prevented, so that stable characteristics are obtained.

In order to accomplish the objects, the present invention deposits a PSG film on a W film and then performs ion implantation or heat treatment, thereby to prevent the oxidation of the W film, the occurrence of the channeling, the degradations of the characteristics of the interface between the W film and an $SiO_2$·film underlying it, etc.

Brief Description of the Drawings

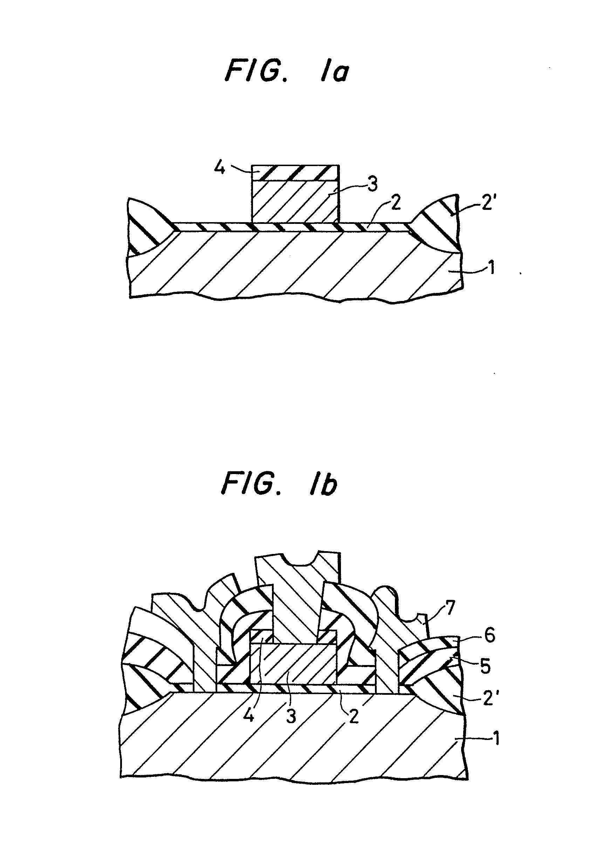

Figures 1a and 1b are sectional flow diagrams for explaining an embodiment of the present invention.

Detailed Description of the Preferred Embodiments

As described before, when ion implantation is carried out using a stacked film (W/$SiO_2$ film) consisting of a W film and an $SiO_2$ film as a mask, some of ions pass through the W/$SiO_2$ film and are implanted into the semiconductor substrate underlying the W/$SiO_2$ film.

Such channeling phenomenon is attributed to the fact that the W film has a low stopping effect on the ions and functions unsatisfactorily as the mask at the ion implantation.

The degradations of the characteristics of the interface between the W film and the $SiO_2$ film arise due to the fact that Na (sodium) ions mix into the W film and then into the interface during various steps. The threshold voltage of a MOS transistor fluctuates conspicuously on account of the Na ions having mixed in.

Moreover, W is very liable to oxidation. By way of example, it has been noted that, when the W is heat-treated in nitrogen, its surface is oxidized by a very small amount of oxygen contained as an impurity in the nitrogen gas.

It has been found out that these problems involved when using W as the electrically conductive material of the electrode or interconnection of a semiconductor device can be effectively prevented by stacking and forming a PSG film on the W film.

That is, when the PSG film is formed on the W film and the resultant structure is heat-treated, the diffusion of oxygen into the W film from the atmosphere during the heat treatment step is checked, and the oxidation of the W film is effectively prevented.

It has also been revealed that, when a PSG film of an appropriate thickness exists on the W film at the ion implantation, channeling does not arise at all.

Besides, when the PSG film exists on the W film, the PSG film acts as a getter for alkali ions such as the Na ions, so that the Na ions etc. are prevented from entering the W film and the insulator film, such as the $SiO_2$ film, underlying it. Therefore, the characteristics of the $W-SiO_2$ interface are stabilized, and the threshold voltage $V_{TH}$ is prevented from fluctuating.

Such prevention of the drawbacks of the Na ions by the PSG film is conjectured to be the effect of P (phosphorus) ions which exist in the PSG film. An $SiO_2$ film containing no P ions at all does not exhibit such effect of stabilizing the $W-SiO_2$ interface characteristics.

As thus far stated, when the electrode or interconnection is formed by forming the PSG film on the W film, there are attained the very excellent effects of preventing the oxidation of the W film, preventing the occurrence of the channeling and stabilizing the threshold voltage $V_{TH}$.

These excellent effects are achieved only when the PSG film is formed on the W film. When any film other than a PSG film is formed on the W film, favorable results are not attained. When the W film is replaced with a Mo film and the PSG film is formed on the Mo film, favorable results cannot be obtained, either.

By way of example, when an $SiO_2$ film is formed

on the W film, the $SiO_2$ film on the W film is very liable to peel off, and besides, it cannot prevent the fluctuation of the threshold voltage $V_{TH}$ attributed to the Na ions.

When the film formed on the W film is a polycrystalline silicon film, the channeling at the ion implantation can be prevented. This measure, however, is not preferable, either, for the following reason. Due to the heat treatment which is conducted after the ion implantation, the W and polycrystalline silicon react to produce tungsten silicide, resulting in an increased electric resistance and the occurrence of deformation.

When an $Si_3N_4$ (silicon nitride) film is used as the film on the W film, this W film is deteriorated by ammonia gas which is used for forming the $Si_3N_4$ film, and the threshold voltage $V_{TH}$ fluctuates drastically.

Even when a BSG (borosilicate glass) film is used instead of the PSG film, the degradation of the $W-SiO_2$ interface characteristics attributed to the Na ions and the consequent fluctuation of the threshold voltage cannot be prevented because the BSG film does not have the action of gettering the Na ions.

When a film of $WO_3$ (tungsten trioxide) which is an oxide of the W itself is formed on the W film, the channeling at the ion implantation can be prevented. This measure, however, cannot be put into practical use

- 8 -

0108251

because the $WO_3$ film volatilizes at the annealing which is performed after the ion implantation.

When the W film is replaced with a Mo film and the PSG film is formed on the Mo film, a part of the PSG film peels off as will be described later. It is therefore difficult to fabricate a semiconductor device.

Example 1:

A W film having a thickness of 350 nm, and a PSG film having a thickness of 40 nm and a P content (concentration of phosphorus oxide, to be exact) of 12 mol % were stacked and formed on an $SiC_2$ film formed on a semiconductor substrate. The stacked structure thus obtained was heat-treated in an $N_2$ atmosphere at 1,000 $^oC$ for 60 minutes. Thereafter, the PSG film was removed, and the state of the surface of the W film was investigated by X-ray photoelectron spectrometry.

Then, it has been noted that the surface of the W film is much less oxidized than in a case of using no PSG film and that the PSG film is very effective for preventing the oxidation of the W film even when it is about 40 nm thick.

Example 2:

Figures 1a and 1b show a process for producing a MOS transistor whose gate is formed by a stacked film consisting of a W film and a PSG film according to the present invention.

As shown in Figure la, a thick oxide film 2' and a thin gate oxide film 2 (which was 20 nm thick) were formed on the (100) plane of a p-type Si substrate 1 by well-known methods.  A W film 3 was subsequently formed by sputtering evaporation, and a PSG film 4 was formed thereon by well-known normal-pressure CVD (chemical vapor deposition).  The resultant structure was annealed at 1,000 $^{o}$C for 30 minutes.

Using a photoresist film as a mask, the unnecessary parts of the W film 3 and the PSG film 4 were etched and removed, and electrodes and interconnections each having a PSG/W/SiO$_2$ structure were formed.

Subsequently, using the PSG film 4, W film 3 and thick SiO$_2$ film 2' as a mask, As (arsenic) ions were implanted under the conditions of an acceleration voltage of 80 keV and a dose of 5 x 10$^{15}$ ions/cm$^{-2}$, whereupon the implanted ions were diffused by drive-in diffusion at 900 $^{o}$C for 30 minutes so as to form doped regions (source and drain regions, not shown).

As shown in Figure 1b, an Si$_3$N$_4$ film 5 having a thickness of 70 nm and a PSG film 6 having a thickness of 500 nm and a P concentration (concentration of phosphorus oxide) of 12 mol % were successively formed as inter-layer insulator films.  Thereafter, contact holes were formed in the insulator films by well-known photoetching, and aluminum electrodes 7 were formed. Then, the MOS transistor was finished up.

When the thickness of the PSG film 4 is greater than about 100 nm, the W film 3 is conspicuously side-etched at the dry etching of the PSG film 4, and the PSG film 4 sometimes peels away from the W film 3 at the annealing subsequent to the ion implantation. It has accordingly been found that a value which is not greater than about 100 nm is preferable as the thickness of the PSG film 4.

In addition, when the thickness of the PSG film 4 is less than about 20 nm, it is sometimes the case that the channeling arises and that the threshold voltage $V_{TH}$ fluctuates. It has accordingly been found that a thickness value which is not less than 20 nm is preferable.

On the other side, it has been noted that when the P concentration of the PSG film 4 is less than about 1.2 mol %, the PSG film 4 is liable to peel off and partly peels away from the W film 3 during the processing thereof. Further drawbacks are that the threshold voltage $V_{TH}$ fluctuates and that the breakdown voltage lowers. It is therefore unpreferable to make the P concentration of the PSG film 4 less than about 1.2 mol %.

However, when the P concentration is greater than about 14 mol %, P in the PSG film 4 passes through the W film 3 and enters the $SiO_2$ film 2 during the annealing, with the result that the threshold voltage $V_{TH}$ fluctuates.

- 11 -

0108251

Therefore, a P concentration value greater than about 14 mol % should better be avoided.

After all, it is preferable to make the P concentration of the PSG film 4 about 1.2 to 14 mol %. More preferable results are obtained with values of about 1.5 to 12 mol %.

It has been noted that, when the thickness of the PSG film is set at about 20-100 nm and the P concentration (concentration of phosphorus oxide, to be exact) thereof at about 1.2-14 mol %, more preferably 1.5 - 12 mol %, the channeling can be effectively prevented, and the characteristics of a semiconductor device produced are favorable.

Comparative Example:

A PSG film having a P concentration of 12 mol % and a thickness of 60 nm was formed on a Mo film having a thickness of 350 nm, and the resultant structure was heated in an $N_2$ atmosphere for 60 minutes. Then, the surface of the PSG film bulged, and a part of the PSG film peeled away from the Mo film.

On the other hand, when similar processing was performed using a W film instead of the Mo film, the PSG film did not peel off. It was accordingly noted that a W film is usable in the present invention while a Mo film is not.

Example 3:

A Mo film and a W film each of which was 350 nm in thickness and 300 x 360 $\mu m^2$ in area were respectively formed on $SiO_2$ films each of which was 20 nm in thickness. After the resultant structures were heated in an $H_2$ atmosphere at 1,000 $^oC$ for 50 minutes, the breakdown voltages of the $SiO_2$ films were measured.

As a result, it has been found that when the W film is formed on the $SiO_2$ film, the breakdown voltage is much more excellent than in the case of forming the Mo film.

When the cause thereof was studied by X-ray photoelectron spectrometry, it was observed that in the case of using the Mo film, Mo and $SiO_2$ reacted to modify the quality of a part of the $SiO_2$. In the case of the W film, the reaction with the $SiO_2$ was much less than in the case of Mo.

Accordingly, in a case where the $SiO_2$ film is as thin as in the present example, it is favorable to employ the W film for a gate electrode and to form a $PSG/W/SiO_2$ structure.

As described above, the present invention is characterized in that a PSG film is formed on a W film so as to put an electrode or interconnection into a structure of PSG/W/insulator film. The electrode or interconnection of such construction can be formed very easily as stated below.

On an insulator film such as an $SiO_2$ film or a stacked film of $SiO_2$ and $Si_3N_4$ formed on a semiconductor substrate, a W film and a PSG film are stacked and formed by well-known methods, whereupon the unnecessary parts of the W film and the PSG film are removed by well-known dry etching such as reactive sputter etching. Thus, the electrode or interconnection having a desired shape is formed.

The most important feature of the present invention consists in that an electrode or interconnection is constructed by forming a PSG film on a W film. Since an $SiO_2$ film is equivalent to a PSG film having no P content, it brings about no favorable result when formed on the W film, as stated before. In the present invention, it is only the PSG film that produces a favorable result when formed on the W film.

The present invention can form an electrode or interconnection, for example, the electrode of a MOS transistor or the interconnection of a bipolar transistor, alone. Meanwhile, in the MOS transistor, it is often the case that a part of its gate electrode is extended and that the extended part serves as an interconnection. Needless to say, the present invention is also applicable to such a case.

The insulator film intervening between the semiconductor substrate and the W film may be a single film of $SiO_2$ or a stacked film consisting of an $SiO_2$ film and an $Si_3N_4$ film. The thickness of the insulator film is approximately 10 nm - 200 nm in case of the electrode of the MOS transistor, and approximately 10 nm - 500 nm in case of the interconnection.

Although the thickness of the W film differs depending upon the kind of a semiconductor device, etc., it is selected from a range of approximately 100 nm to 1,000 nm.

What is claimed is:

1.   A semiconductor device comprising an electrode and/or an interconnection made of a stacked film of a tungsten film (3) and a phosphosilicate glass film (4) which are stacked and formed on an insulator film (2) formed on a semiconductor substrate (1) and which have a desired shape.

2.   A semiconductor device according to claim 1, wherein said phosphosilicate glass film (4) has a phosphorus oxide concentration of approximately 1.2 to 14 mol %, preferably 1.5 to 12 mol %.

3.   A semiconductor device according to claim 1 or 2, wherein said phosphosilicate glass film (4) has a thickness of approximately 20 to 100 nm.

4.   A semiconductor device according to any of claims 1 to 3, wherein said tungsten film (3) has a thickness of approximately 100 nm to 1,000 nm.

5.   A semiconductor device according to any of claims 1 to 4, wherein said tungsten film (3) is a gate electrode of a MOS transistor.

FIG. Ia

FIG. Ib